# EUROPEAN PATENT APPLICATION

(11) **EP 4 148 997 A1**
(43) Date of publication of application: **15.03.2023**
(21) Application number: 21800399.4
(22) Date of filing: 07.05.2021
(51) Int. Cl.: H03H 9/02, H03H 9/05, H03H 9/17

(54) **BULK ACOUSTIC WAVE RESONATOR, FILTER, ELECTRONIC DEVICE, AND METHOD FOR ADJUSTING ELECTROMECHANICAL COUPLING COEFFICIENT**

(30) Priority: 07.05.2020 CN 202010376103
(71) Applicant: Rofs Microsystem (Tianjin) Co., Ltd, Tianjin 300462 (CN)
(72) Inventor: BAN, Shengguang, Tianjin 300462 (CN); PANG, Wei, Tianjin 300072 (CN); XU, Yang, Tianjin 300462 (CN)
(74) Representative: Meyer-Dulheuer MD Legal Patentanwälte PartG mbB
(86) International application number: PCT/CN2021/092059
(87) International publication number: WO 2021/223731

(57) **Abstract**

The present disclosure relates to a bulk acoustic wave resonator, including: a substrate, an acoustic mirror, a bottom electrode, a top electrode, and a piezoelectric layer. The top electrode is provided with raised portions at both a top electrode connection end and a non-top electrode connection end, and the top surfaces of the raised portions are above the top surface of an inner side portion of the top electrode; the inner side portion is a convex polygonal area having multiple edges, the raised portions are arranged around the convex polygonal area to form a polygonal electrode frame, and the electrode frame includes multiple frame edges; the frame edges of the electrode frame have transverse width changes in the acoustic mirror. The present disclosure also relates to a filter, at least one resonator of the filter being the above resonator and having an electromechanical coupling coefficient different from those of other resonators. The present disclosure also relates to an electronic device including the above bulk acoustic wave resonator or filter, and a method for adjusting the electromechanical coupling coefficient of the bulk acoustic wave resonator.

## Description

### TECHNICAL FIELD

Embodiments of the present disclosure relate to the field of semiconductors, and in particular, to a bulk acoustic wave resonator method, a filter having the resonator, a method of adjusting an electromechanical coupling coefficient of the bulk acoustic wave resonator, and an electronic device having the filter or the resonator.

### BACKGROUND

A bulk acoustic wave filter has the advantages of low insertion loss, high rectangular coefficient, high power capacity and the like, and thus is widely applied to the current wireless communication system and is an important component for determining the quality of a radio-frequency signal for entering and exiting the communication system.

In order to improve the excellent performance of the filter, each resonator needs to have different performance, therefore how to accurately regulate and control the performance of each resonator that forms the bulk acoustic wave filter is the direction of the subsequent key research for the bulk acoustic wave filter.

The filter is composed of resonators with two functions, that is, series connection and parallel connection. For the parallel or serial resonators, due to the same film layer structure and the same protrusion structure, the performance difference therebetween is not significant, which is unfavorable to improving the performance of the filter.

An electromechanical coupling coefficient (kt²) for the same frequency on the same substrate is not adjustable, and if the frequency of the resonator is determined, the electromechanical coupling coefficient of the resonator is generally determined. However, the current development demand requires resonators with different electromechanical coupling coefficients under the same frequency or specific frequency difference. However, resonators with the same frequency and different electromechanical coupling coefficients need to be used in practice. Thus, there is a need in the related art to provide different resonators, for example, two resonators, on the same substrate, which may, for example, have the same frequency on the same substrate while having different electromechanical coupling coefficients.

### SUMMARY

In order to solve at least one aspect of the above technical problems in the related art, the present disclosure provides a new structural solution to improve the degree of freedom of an electromechanical coupling coefficient of a bulk acoustic wave resonator, such that the performance of a filter can be further improved.

According to one aspect of embodiments of the present disclosure, a bulk acoustic wave resonator is provided that includes a substrate, an acoustic mirror, a bottom electrode, a top electrode, and a piezoelectric layer. The top electrode is provided with bulge portions at both a top-electrode connection end and a non-top-electrode connection end, and top surfaces of the bulge portions are higher than a top surface of an inner side portion of the top electrode. The inner side portion is a convex polygonal region having edges, the bulge portions are arranged around the convex polygonal region to form an electrode frame with a polygonal shape, and the electrode frame includes a plurality of frame edges. The plurality of frame edges of the electrode frame has lateral width change within the acoustic mirror.

The embodiments of the present disclosure further relate to a method of adjusting an electromechanical coupling coefficient of the above bulk acoustic wave resonator. The method includes a step of adjusting the electromechanical coupling coefficient by adjusting the widths of the plurality of frame edges of the electrode frame within the acoustic mirror in the lateral direction. Optionally, the method further includes a step of adjusting the electromechanical coupling coefficient by selecting a ratio of a number of frame edges of the plurality of frame edges that have adjusted widths to a total number of the plurality of frame edges of the electrode frame.

The embodiments of the present disclosure further relate to a filter. The filter includes a series branch including a plurality of series resonators and a plurality of parallel branch, and each of the plurality of parallel branches includes a parallel resonator. At least one resonator of the parallel resonators and the plurality of series resonators has an electromechanical coupling coefficient that is different from electromechanical coupling coefficients of other resonators of the parallel resonators and the plurality of series resonators, and the at least one resonator is the above bulk acoustic wave resonator.

The embodiments of the present disclosure further relate to an electronic device including the above filter or the resonator.

### BRIEF DESCRIPTION OF DRAWINGS

The following description and drawings may help understand these and other features and advantages in various embodiments of the present disclosure. The same reference signs in the drawings always indicate the same components.
FIG. 1 is a top view of a bulk acoustic wave resonator according to an exemplary embodiment of the present disclosure.
FIG. 2 is a schematic sectional view along line 1A-1A in FIG. 1.
FIG. 3A and FIG. 3B are cross-sectional views for exemplarily illustrating an insertion layer in FIG. 2.
FIG. 4 is a schematic sectional view of a bulk acoustic wave resonator according to an exemplary embodiment of the present disclosure, which is similarly taken along line 1A-1A in FIG. 1.
FIGS. 5A-5F are cross-sectional views for exemplarily illustrating an insertion layer in FIG. 4, respectively.
FIG. 6 is a schematic sectional view of a bulk acoustic wave resonator according to an exemplary embodiment of the present disclosure, which is similarly taken along line 1A-1A in FIG. 1.
FIGS. 7A-7B are cross-sectional views for exemplarily illustrating an insertion layer in FIG. 6, respectively.
FIG. 8 is a schematic sectional view of a bulk acoustic wave resonator according to an exemplary embodiment of the present disclosure, which is similarly taken along line 1A-1A in FIG. 1.
FIGS. 9A-9D are cross-sectional views for exemplarily illustrating an insertion layer in FIG. 8, respectively.
FIG. 10 is a schematic sectional view of a bulk acoustic wave resonator according to an exemplary embodiment of the present disclosure, which is similarly taken along line 1A-1A in FIG. 1.
FIGS. 11A-11C are cross-sectional views for exemplarily illustrating an insertion layer in FIG. 10, respectively.
FIG. 12 is a change graph of parallel impedance (Rp) of a resonator with a conventional protrusion structure and a width W of the protrusion structure.

### DESCRIPTION OF EMBODIMENTS

The technical solutions of the present disclosure will be further described in detail below through embodiments and in conjunction with the drawings. The following description of the embodiments of the present disclosure with reference to the drawings is intended to explain the general inventive concept of the present disclosure, and should not be construed as limitation to the present disclosure.

In the present disclosure, the reference signs are exemplarily described as follows:
101: a substrate, which may be made of a material such as monocrystalline Si, quartz, SiC, GaN, GaAs, sapphire, or diamond;
102: an acoustic mirror, which is an air cavity structure in the present embodiment, and may be of a Bragg reflection layer or other equivalent acoustic wave reflection structures;
103: a bottom electrode, which may be made of a material such as molybdenum, ruthenium, gold, aluminum, magnesium, tungsten, copper, titanium, iridium, osmium, chromium, or composites or alloys thereof;
104: a piezoelectric film layer, which may be made of a material such as aluminum nitride, zinc oxide, or PZT, and may contain rare earth element doped materials with a certain atomic ratio of the above materials;
107: a top electrode, which may be made of a material such as molybdenum, ruthenium, gold, aluminum, magnesium, tungsten, copper, titanium, iridium, osmium, chromium, or composites or alloys thereof;
105: a protrusion structure, which may be made of a material such as molybdenum, ruthenium, gold, aluminum, magnesium, tungsten, copper, titanium, iridium, osmium, chromium, or composites or alloys thereof;
109: an air gap or a filled medium material;
112: a passivation layer, which is generally made of a medium material, such as silicon dioxide and aluminum nitride;
113: a wing structure, which is formed by a non-connection edge of a resonator directly above the air gap 109; and
114: a bridge structure, which is formed by a connection edge of the resonator directly above the air gap 109.

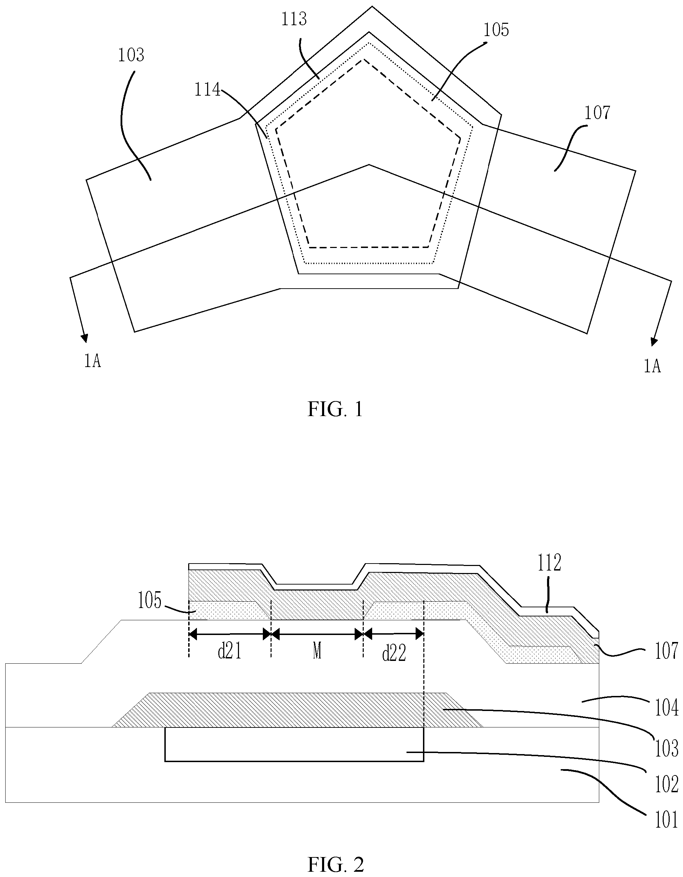

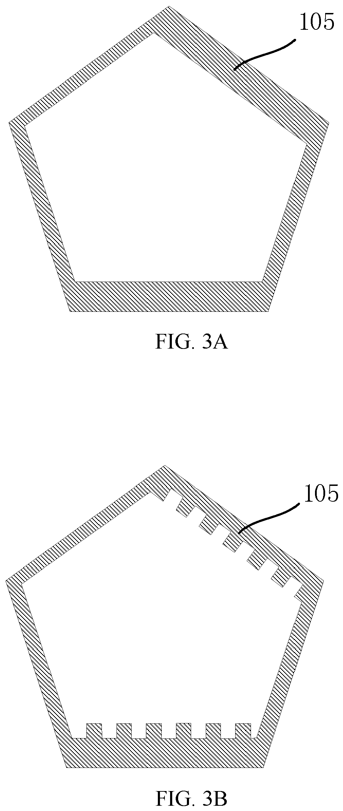

A bulk acoustic wave resonator according to an embodiment of the present disclosure is exemplarily described below with reference to FIGS. 1-3A. FIG. 1 is a top view of a bulk acoustic wave resonator according to an exemplary embodiment of the present disclosure, FIG. 2 is a schematic sectional view along line 1A-1A in FIG. 1, and FIG. 3A is a cross-sectional view for exemplarily illustrating an insertion layer in FIG. 1A. In FIG. 1, an effective region of the resonator has a convex pentagonal structure, but the present disclosure is not limited thereto and may be other convex polygonal structures.

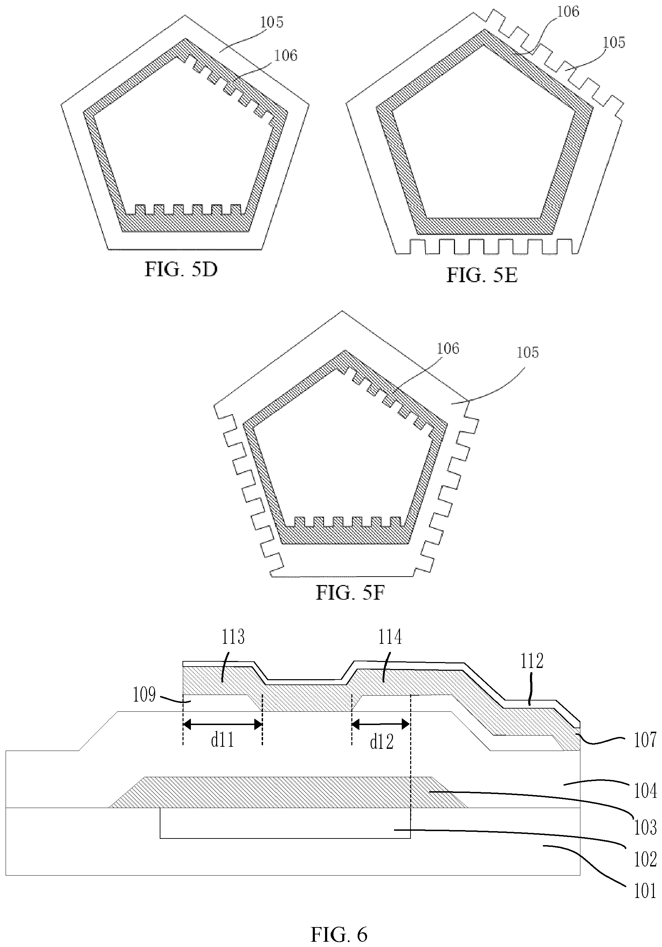

As shown in FIG. 2, the resonator is only provided with a protrusion structure 105, but is not provided with an air gap structure (as shown later in FIG. 6).

The protrusion structure 105 may have different widths on different edges of a pentagon, d21 and d22 in FIG. 2. In the present disclosure, the width of an edge is a width within a boundary of an acoustic mirror along a lateral direction or radial direction of the resonator. That is, the width of the protrusion structure on each edge of the pentagon is different, and the difference in width herein means that the width of at least one edge is different from the widths of the remaining edges. An electromechanical coupling coefficient of the resonator can be adjusted by changing the width of the protrusion structure 105 on each edge and the proportion of each width for the five edges (i.e., the ratio of the number of edges with adjusted widths to the total number of edges of the polygon). Further, each edge is provided with the protrusion structure, such that the parallel impedance Rp (or a quality factor Qp) at a parallel resonance frequency may be kept at a relatively high level without a significant drop that may be caused by the adjustment of the width of the protrusion structure on each edge.

As shown in FIG. 2, due to the presence of the protrusion structure 105, the top electrode 107 is provided with bulge portions both at a top-electrode connection end (right side in FIG. 2) and a non-top-electrode connection end (left side in FIG. 2). It is evident from the figure that the bulge portion includes the wing structure 113 and a part of the bridge structure 114 in FIG. 6. In FIG. 2, a top surface of the bulge portion is higher than a top surface of an inner side portion M of the top electrode. As shown in FIG. 1, the inner side portion M of the top electrode is a convex polygonal region having five edges, the bulge portion is arranged around the convex polygonal region to form a polygonal electrode frame, and the electrode frame includes a plurality of frame edges. In FIG. 6, the electrode frame is formed of the wing structure 113 and the bridge structure 114 that is located on an inner side of an acoustic mirror.

As shown in FIG. 2, the protrusion structure 105 is arranged below the electrode frame.

When the pentagonal protrusion structures of the resonator have the same width, the widths of the protrusion structures have a corresponding relationship with the electromechanical coupling coefficient kt² of the resonator. For example, when the widths of the protrusion structures on the five edges of the resonator are all 2 µm, the corresponding kt² is 8.0%, and when the widths of the protrusion structures on the five edges of the resonator are all 5 µm, the corresponding kt² is 7.5%. In general, the electromechanical coupling coefficients of resonators with the same area decrease as the widths of the protrusion structures increase.

In the present disclosure, the plurality of frame edges of the electrode frame of the resonator has different widths. In this way, when the widths of the electrode frame are consistent with those of the protrusion structure (i.e., an inner side starting point is consistent with an outer side ending point), the widths of the electrode frame may be determined by the widths of the protrusion structures 105. In an embodiment, as shown in FIG. 2 and FIG. 3A, the five edges of the protrusion structure 105 are configured to have different protrusion structure widths, such that kt² of the resonator can be adjusted and other properties (e.g., a Q value at a parallel resonator frequency) are substantially unaffected. Further, kt² can be further adjusted by selecting the number of edges of the protrusion structure of each width. For example, when the widths of five edges of the protrusion structure are all 2 µm, kt² is 8.0%; when the widths of four edges of the protrusion structure are all 2 µm and the width of another edge is 5 µm, kt² is 7.9%; when the widths of three edges of the protrusion structure are all 2 µm and the widths of other two edges are 5 µm, kt² is 7.8%; when the widths of two edges of the protrusion structure are both 2 µm and the widths of other three edges are 5 µm, kt² is 7.7%; when the width of one edge of the protrusion structure is 2 µm and the widths of other four edges are 5 µm, kt² is 7.6%; and when the widths of five edges of the protrusion structure are all 5 µm, kt² is 7.5%.

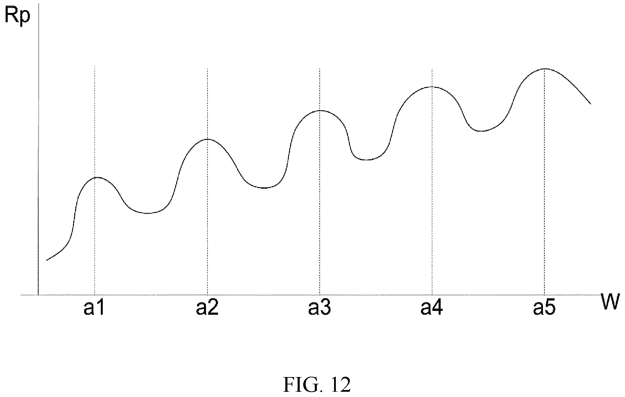

FIG. 12 is a change graph of parallel impedance (Rp) of a resonator that is provided with a conventional protrusion structure versus the widths W of the protrusion structure. The traditional protrusion structure refers to a case where widths of all edges of the protrusion structures in one resonator are the same. As shown in FIG. 12, the value of the parallel impedance Rp exhibits periodic characteristics with the increase in the width W, and each period has a peak point. As shown in FIG. 12, the widths a1, a2, a3, a4, a5, and the like of the protrusion structure corresponding to local peak values approximately satisfy a proportional relationship of a1: a2: a3: a4: a5:... = 1: 3: 5: 7: 9:.... Moreover, the electromechanical coupling coefficient monotonically decreases along with the increase in the widths of the protrusion structure. Therefore, in order to adjust kt² of a resonator and ensure that the value of the parallel impedance Rp of the resonator substantially remains unchanged, the widths of the protrusion structure corresponding to the peak values in different periods may be combined. For example, as described above, the width of the protrusion structure corresponding to the peak value of the first period is 2 µm, and the width of the protrusion structure corresponding to the peak value of the second period is 5 µm. In this embodiment, the protrusion structures with such two widths are combined on one resonator, so that the parallel impedance Rp can be maintained at a peak value level on the basis of adjusting kt².

In the present disclosure, on the premise of not changing the preparation steps of the resonator, the electromechanical coupling coefficient of the resonator is freely adjusted in a range without influence on other performance.

In other words, since a filter has a specific frequency and bandwidth, the resonator for forming the filter can satisfy the above requirements by setting specific thicknesses of the bottom electrode, the piezoelectric layer, and the top electrode and the electromechanical coupling coefficient thereof is thus substantially determined. However, in an actual design process of the filter, in order to achieve excellent performance, it is required that the electromechanical coupling coefficients of different resonators are different from each other. In the present disclosure, on the premise not increasing the process difficulty, the electromechanical coupling coefficient can be adjusted in a range by providing different protrusion structures on each edge of the resonator and configuring different widths of the wing and the bridge structure. Therefore, the electromechanical coupling coefficient is flexibly adjusted by selecting widths of two or more protrusion structures or widths of two or more wings or bridges on different edges of the resonator and controlling the proportion of each width to the five edges.

The bottom electrode, the piezoelectric layer and the top electrode may determine great adjustment of the electromechanical coupling coefficient of the resonator, and the solution provided by the present disclosure may realize slight adjustment of the electromechanical coupling coefficient.

As shown in FIG. 3A, the boundary of the protrusion structure 105 is linear. In other words, an inner side boundary and an outer side boundary of the protrusion structure 105 are both straight lines. However, the present disclosure is not limited thereto. As shown in FIG. 3B, the inner sides of two edges of the protrusion structure 105 have concave-convex shapes. It should be noted that the concave-convex shape herein includes the concave-convex shapes in the claims, which not only include a zigzag shape in which a convex cross section or concave cross-section is rectangular as shown in FIG. 3A, but also include other shapes in which the convex cross sections or concave cross sections are nonlinear.

It should also be noted that, it is shown in FIG. 3B that the concave-convex shape is arranged on the inner side of the protrusion structure, but the present disclosure is not limited thereto, and the concave-convex shape may be arranged on the outer side of the protrusion structure. In addition, concave-convex shapes may be arranged on the inner side and the outer side of one edge of the protrusion structure, or a concave-convex shape is arranged on the outer side of one edge and another concave-convex shape is arranged on the inner side of another edge.

In the embodiments shown in the present disclosure, when the frame edge of an insertion frame has a concave-convex shape, the width of the frame edge of the insertion frame is determined by a maximum width thereof.

In the embodiments shown in FIGS. 1-3, the protrusion structure 105 is an insertion layer, which is located between the top electrode and the piezoelectric layer. The insertion layer is arranged between the top electrode 107 and the piezoelectric layer 104. The bulge portion includes a bridge portion or bridge structure 114 at the top-electrode connection end and a wing portion or wing structure 113 at the non-top-electrode connection end. The insertion layer includes an insertion frame that corresponds to the protrusion structure 105 in FIG. 3A or 3B and is located in the acoustic mirror in the lateral direction. The insertion frame and the electrode frame have the same inner side boundary and outer side boundary in the lateral direction.

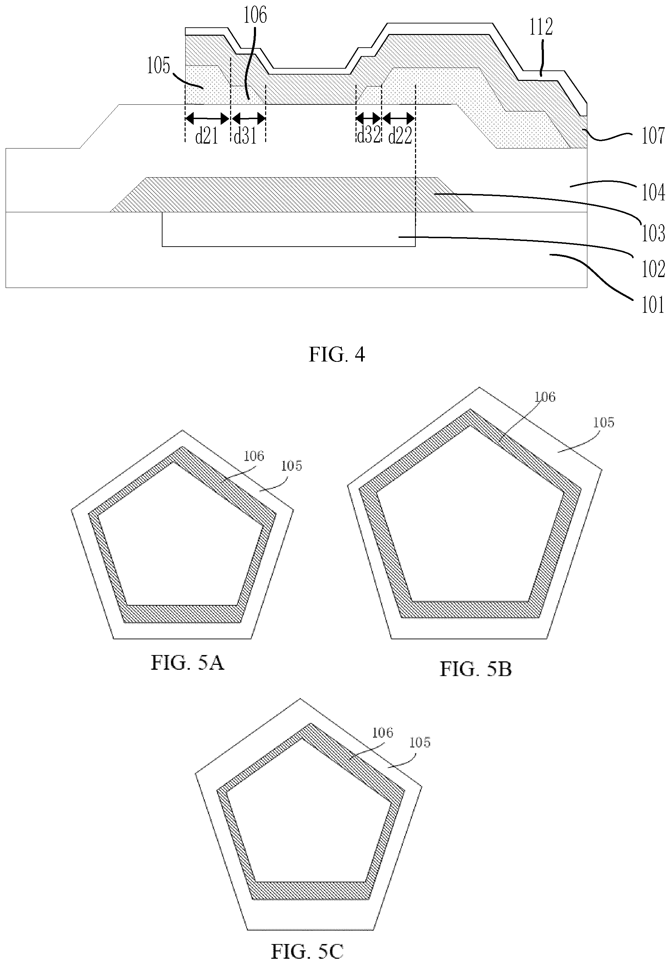

FIG. 4 is a schematic sectional view of a bulk acoustic wave resonator according to an exemplary embodiment of the present disclosure, which is similarly taken along line 1A-1A in FIG. 1. Unlike that in FIG. 2, the cross section of the protrusion structure in FIG. 4 has a step shape. In other words, the protrusion structure includes a first protrusion structure 105 and a second protrusion structure 106. In FIG. 4, the first protrusion structure 105 is located on the outer side and the second protrusion structure 106 is located on the inner side. In the present disclosure, a side close to the center of the resonator in the lateral direction is an inner side, and a side away from the center of the resonator is an outer side.

In FIG. 4, the first protrusion structure 105 and the second protrusion structure 106 form an insertion layer. The first protrusion structure 105 is a first insertion sub-layer, and the second protrusion structure 106 is a second insertion sub-layer. In FIG. 4, the frame edge of the insertion frame of the insertion layer, which is located on the inner side of the boundary of the acoustic mirror, forms a step frame edge with a height increasing from the inner side to the outer side, and each insertion sub-layer forms a corresponding insertion sub-frame.

FIGS. 5A-5C are respectively cross-sectional views for exemplarily illustrating the insertion layer in FIG. 4, in which the frame edges of the insertion sub-frame are straight frame edges having straight inner side boundaries and straight outer side boundaries.

FIGS. 5D-5F are respectively cross-sectional views for exemplarily illustrating the insertion layer in FIG. 4. In an embodiment, an inner side of a second insertion sub-frame corresponding to 106 has a concave-convex shape and a first insertion sub-frame corresponding to 105 has a straight edge, as shown in FIG. 5D. In another embodiment, an outer side of the first insertion sub-frame corresponding to 105 has a concave-convex shape and the second insertion sub-frame corresponding to 106 has a straight edge, as shown in FIG. 5E. In an embodiment, the outer side of the first insertion sub-frame corresponding to 105 has a concave-convex shape and the inner side of the second insertion sub-frame corresponding to 106 has a concave-convex shape, as shown in FIG. 5F. The present disclosure is not limited thereto, but includes the solution that an inner side boundary and/or an outer side boundary of at least one frame edge of at least one insertion sub-frame has a concave-convex shape.

As shown in FIGS. 5A-5F, widths of the frame edges of the insertion frame may be configured in such a manner that, as shown in FIG. 5A, widths of the frame edges of the second insertion sub-frame corresponding to 106 are different (e.g., d31 is different from d32 in FIG. 4), and the widths of the frame edges of the first insertion sub-frame corresponding to 105 are the same. The widths of the frame edges of the insertion frame may be configured in such a manner that, as shown in FIG. 5B, the widths of the frame edges of the first insertion sub-frame corresponding to 105 are different (e.g., d21 is different from d22 in FIG. 4), and the widths of the frame edges of the second insertion sub-frame corresponding to 106 are the same. The widths of the frame edges of the insertion frame may be configured in such a manner that, as shown in FIG. 5C, the widths of the frame edges of the first insertion sub-frame are different, and the widths of the frame edges of the second insertion sub-frame are different.

It should be noted that, in the embodiments shown in FIG. 4 and FIGS. 5A-5F, when the widths of the frame edges of each insertion sub-frame change, a total width of the frame edges of the insertion frame, i.e. a sum of widths of the first insertion sub-frame and the second insertion sub-frame on the same frame edge, remains unchanged. In an embodiment, a total width of the frame edges of the insertion frame changes.

It should be noted that, in the embodiment shown in FIG. 4, only an embodiment in which the insertion frame is formed by two insertion sub-frames, but the present disclosure is not limited thereto. The insertion frame may be formed by more insertion sub-frames connected to each other in the lateral direction.

It should be noted that in FIG. 4, the first insertion sub-frame and the second insertion sub-frame are shown separately in the lateral direction. However, in an actual manufacturing process, the same thickness portions of the first insertion sub-frame and the second insertion sub-frame may be deposited and patterned, and a portion of the first insertion sub-frame within the same thickness portions, which is higher than the second insertion sub-frame, is then deposited and patterned.

The insertion layer may not be made of a conductive material, and may be made of a non-conductive medium.

FIG. 6 is a schematic sectional view of a bulk acoustic wave resonator according to an exemplary embodiment of the present disclosure, which is similarly taken along the line 1A-1A in FIG. 1. In FIG. 6, an air gap 109 is arranged between a bulge portion of a top electrode and a top surface of a piezoelectric layer.

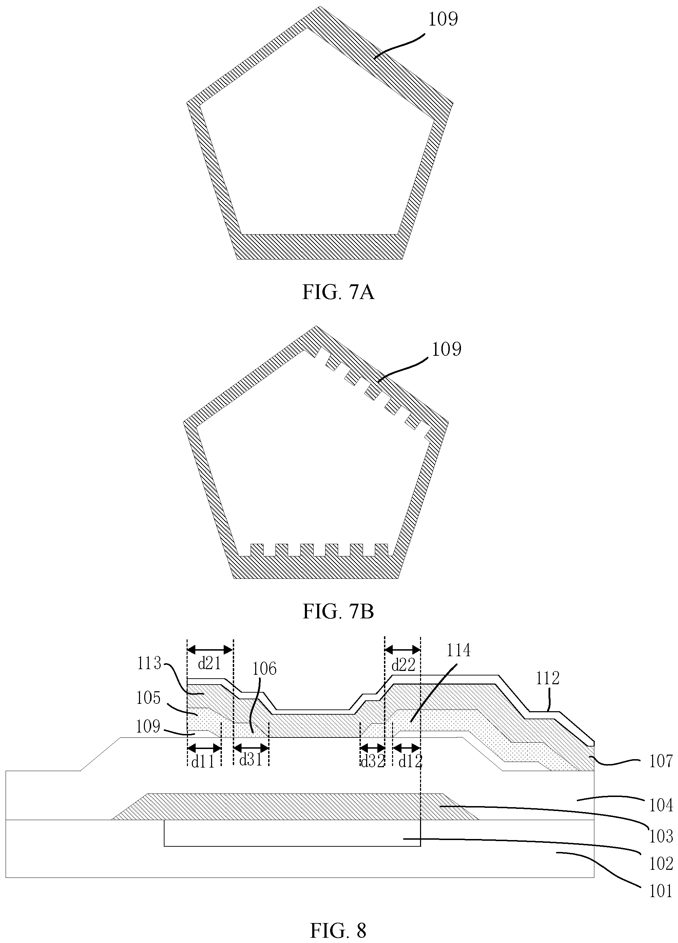

FIG. 7A-7B are cross-sectional views for exemplarily illustrating an insertion layer in FIG. 6, respectively. FIG. 7A illustrates change in widths of frame edges of an insertion frame formed by the air gap 109. As can be understood by those skilled in the art, the description of change in the width of a metal insertion frame as shown in FIG. 3 is also applicable to the air gap insertion frame in FIG. 7A. FIG. 7B illustrates change in the widths of the frame edges of the insertion frame formed by the air gap 109 and concave-convex shapes of the boundaries of the frame edges. As can be understood by those skilled in the art, the description of the change in the width of the metal insertion frame as shown in FIG. 3 is also applicable to the air gap insertion frame in FIG. 7B.

In FIG. 6, air is used as a non-conductive medium, but the present disclosure is not limited thereto. The non-conductive medium may be, for example, aluminum nitride, silicon dioxide, and silicon nitride.

The insertion layer shown in FIG. 4 may be combined with the insertion layer shown in FIG. 6. FIG. 8 is a schematic sectional view of a bulk acoustic wave resonator according to an exemplary embodiment of the present disclosure, which is similarly taken along line 1A-1A in FIG. 1.

As shown in FIG. 8, an insertion layer includes a second insertion sub-layer corresponding to 106 and a first insertion sub-layer corresponding to 105, which are arranged in sequence from the inner side to the outer side in the lateral direction. Frame edges of the insertion layer form a step frame edge from the inner side to the outer side, and each insertion sub-layer is made of a conductive material and forms a corresponding insertion sub-frame. An air gap is formed between the insertion sub-layer located on the outermost side in the lateral direction and the top surface of the piezoelectric layer, and forms a non-conductive frame. It should be noted that the present disclosure is not limited thereto. For example, the step frame edge may have a plurality of steps, may be a combination of the air gap and a conductive insertion sub-layer, or may be a combination of a non-conductive frame that is made of a non-conductive medium and an insertion sub-layer that is made of a conductive material.

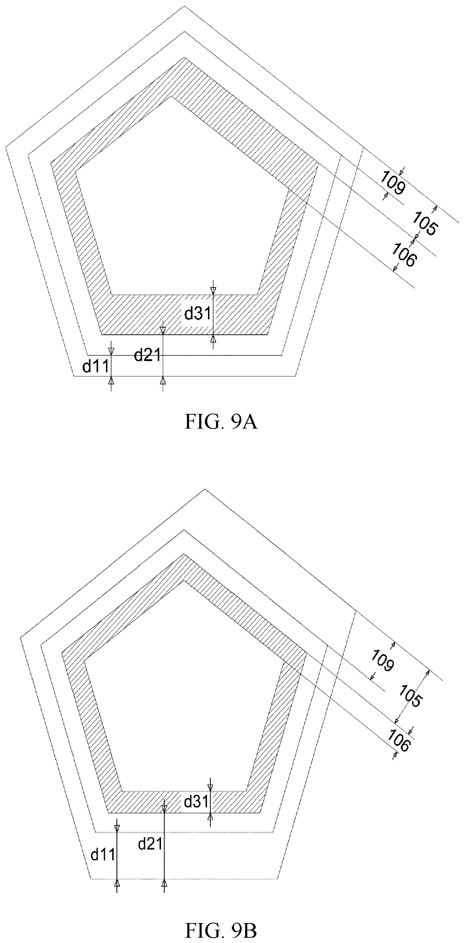

FIGS. 9A-9D are cross-sectional views for exemplarily illustrating the insertion layer in FIG. 8, respectively. As can be understood, widths of a first insertion sub-frame corresponding to 105, a second insertion sub-frame corresponding to 106 and a non-conductive frame corresponding to 109 may change respectively or be different from each other, or may change simultaneously or be different from each other. That is, the widths of the frame edges of the insertion frame in FIG. 8 or the widths of the sub-frames may change. A more specific description will be given below.

In FIG. 9A, the widths of the frame edges of the second insertion sub-frame corresponding to 106 change, e.g., d31 is different from d32 in FIG. 8. The widths of the first insertion sub-frame corresponding to 105 and the non-conductive frame corresponding to 109 do not vary, e.g., d21 is the same as d22 and d11 is the same as d12 in FIG. 8. In FIG. 9A, the widths of the frame edges of the insertion sub-frame formed by the protrusion structure 106 are different, that is, the width d31 of at least one frame edge is different from, for example, the width d32 of the remaining frame edges. The electromechanical coupling coefficient may be further adjusted or selected by changing the widths of the frame edges of the insertion sub-frame formed by the protrusion structure 106 and a proportion of the number of frame edges with each width to the number of five edges.

In FIG. 9B, the widths of the frame edges of the second insertion sub-frame corresponding to 106 do not change, e.g., d31 is the same as d32 in FIG. 8. The widths of the frame edges of the non-conductive frame corresponding to 109 change, e.g., d11 is different from d12 in FIG. 8, and the widths of the frame edges of the first insertion sub-frame corresponding to 105 also change, e.g., d21 is different from d22 in FIG. 8, but a width difference value of the first insertion sub-frame and the non-conductive frame does not change, i.e., d21-d11=d22-d12). In FIG. 9B, the widths of the frame edges of the insertion sub-frame formed by the air gap 109 are different. That is, the width d11 of at least one frame edge is different from, for example, the width d12 of the remaining frame edges. The electromechanical coupling coefficient can be further adjusted or selected by changing the widths of the frame edges of the insertion sub-frame formed by the air gap 109 and the proportion of the number of frame edges with each width to the number of five edges.

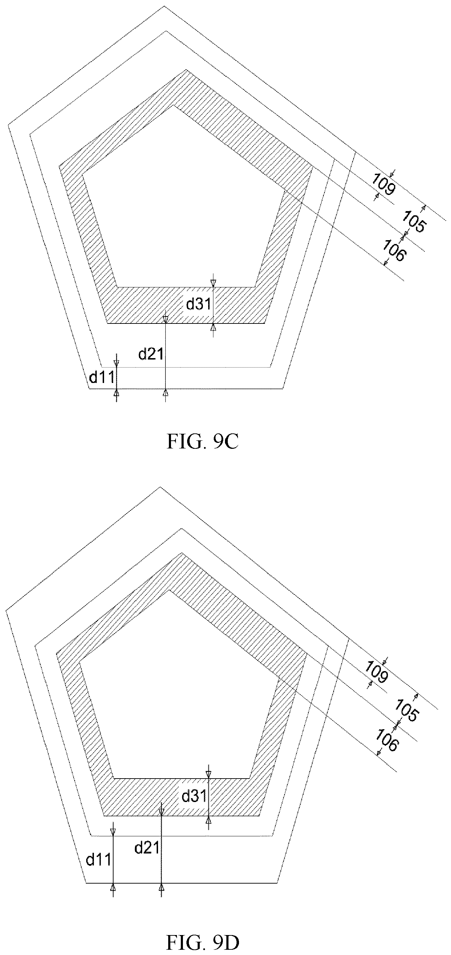

In FIG. 9C, the widths of the frame edges of the non-conductive frame corresponding to 109 do not change, e.g., d11 is the same as d12 in FIG. 8, and the widths of the frame edges of the second insertion sub-frame corresponding to 106 and the widths of the frame edges of the first insertion sub-frame corresponding to 105 change, e.g., d31 is different from d32 and d21 is different from d22 in FIG. 8. In FIG. 9C, the widths of the frame edges of the insertion sub-frame formed by the protrusion structure 105 are different, and the widths of the frame edges of the insertion sub-frame formed by the protrusion structure 106 are different, but the widths of the frame edges of the insertion sub-frame formed by the air gap 109 are the same. The electromechanical coupling coefficient can be further adjusted or selected by changing the widths of the frame edges of the insertion sub-frame formed by the protrusion structure 105, the widths of the frame edges of the insertion sub-frame formed by the protrusion structure 106, and the proportion of the number of frame edges with each width to the number of five edges.

In FIG. 9D, the widths of the frame edges of the second insertion sub-frame corresponding to 106 and the widths of the frame edges of the non-conductive frame corresponding to 109 change, e.g., d11 is different from d12 and d31 is different from d32 in FIG. 8. The widths of the first insertion sub-frame (corresponding to 105) corresponding to the corresponding edge of the non-conductive frame also change, e.g., d21 is different from d22 FIG. 8, but a width difference value of the first insertion sub-frame and the non-conductive frame does not change, i.e., d21-d11=d22-d12). In FIG. 9D, the widths of the frame edges of the insertion sub-frame formed by the air gap 109 are different, the widths of the frame edges of the insertion sub-frame formed by the protrusion structure 105 on the corresponding edge are different, and the widths of the frame edges of the insertion sub-frame formed by the protrusion structure 106 are different. The electromechanical coupling coefficient can be further adjusted or selected by changing the widths of the frame edges of the insertion sub-frame formed by the protrusion structure 105 and the protrusion structure 106, the widths of the frame edges of the insertion sub-frame formed by the air gap 109, and a proportion of the number of frame edges with each width to the number of five edges.

The frame edges of the insertion frame in FIGS. 9A-9D are straight lines. Although not shown, the frame edges of the insertion frame in FIGS. 9A-9D may have concave-convex shapes.

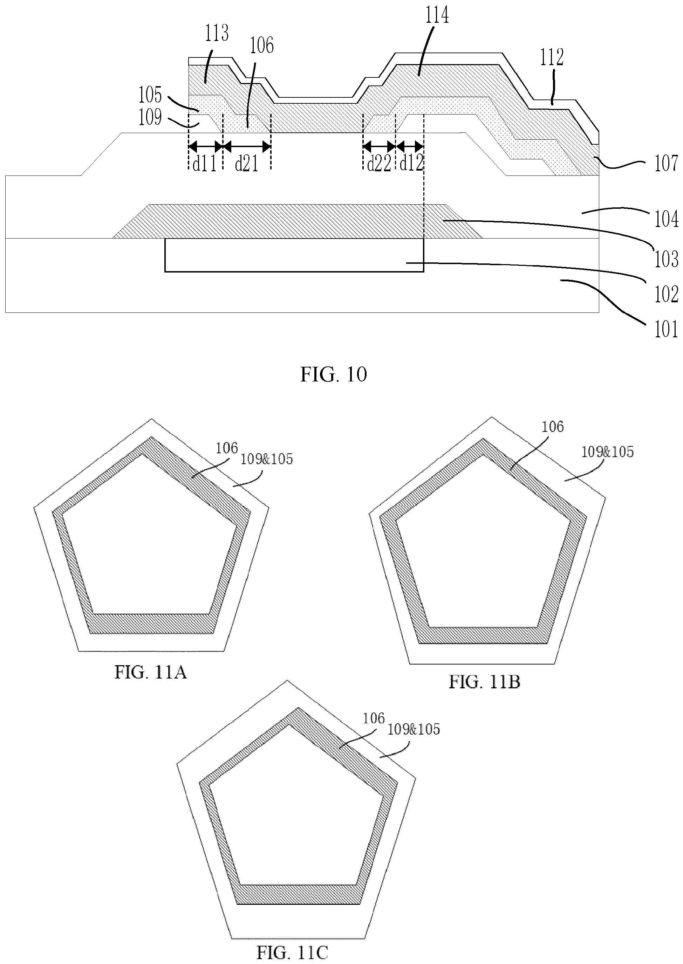

As shown in FIG. 8, the width of the air gap 109 is less than that of the concave-convex structure 105 on a side of the top electrode, but as shown in FIG. 10, the width of the air gap 109 may be consistent with that of the concave-convex structure 105. FIG. 10 is a schematic sectional view of a bulk acoustic wave resonator according to an exemplary embodiment of the present disclosure, which is similarly taken along line 1A-1A in FIG. 1, and FIGS. 11A-11C are cross-sectional views for exemplarily illustrating an insertion layer in FIG. 10, respectively.

In FIG. 11A, the widths of the frame edges of the insertion sub-frame formed by the protrusion structure 106 are different, that is, the width d21 of at least one frame edge is different from, for example, the width d22 of the remaining frame edges. The electromechanical coupling coefficient can be further adjusted or selected by changing the widths of the frame edges of the insertion sub-frame formed by the protrusion structure 106 and a proportion of the number of frame edges with each width to the number of five edges.

In FIG. 11B, the widths of the frame edges of the insertion sub-frame formed by the air gap 109 are different, that is, the width d11 of at least one frame edge is different from, for example, the width d12 of the remaining frame edges. The electromechanical coupling coefficient can be further adjusted or selected by changing the widths of the frame edges of the insertion sub-frame formed by the air gap 109 and s proportion of the number of frame edges with each width to the number of five edges.

In FIG. 11C, the widths of the frame edges of the insertion sub-frame formed by the protrusion structure 106 are different, and the widths of the frame edges of the insertion sub-frame formed by the air gap 109 are different. The electromechanical coupling coefficient can be further adjusted or selected by changing the widths of the frame edges of the insertion sub-frame formed by the protrusion structure 106, the widths of the frame edges of the insertion sub-frame formed by the air gap 109, and a proportion of the number of frame edges with each width to the number of five edges.

The frame edges of the insertion frame in FIGS. 11A-11C are straight lines. Although not shown, the frame edges of the insertion frame in FIGS. 11A-11C may also have concave-convex shapes.

In the embodiments shown and described above, the insertion layer is arranged between the piezoelectric layer and the top electrode, but the present disclosure is not limited thereto. For example, the insertion layer may be arranged between the piezoelectric layer and the bottom electrode.

In the embodiments shown and described above, the widths of the frame edges of the insertion frame of the insertion layer are different in the length direction of the frame edges, but a single frame edge of the insertion frame of the insertion layer may change in the length direction thereof.

In an embodiment of the present disclosure, the thickness of the insertion layer is less than that of the top electrode.

In the present disclosure, on the basis of not increasing process steps, the electromechanical coupling coefficient of the resonator can be further adjusted by changing the width values of the insertion layer (e. g., corresponding to one or more of 105, 106, and 109) on different edges of the resonator, so that the design requirements can be satisfied and the design difficulty is reduced. The inventors have more choices during the development, and the limitation of the resonator frequency to the electromechanical coupling coefficient is removed.

Based on the above embodiments and the drawings thereof, the present disclosure provides the following technical solutions.
1. A bulk acoustic wave resonator includes:
   a sub strate;
   an acoustic mirror;
   a bottom electrode;
   a top electrode; and
   a piezoelectric layer,
   wherein the top electrode is provided with bulge portions at both a top-electrode connection end and a non-top-electrode connection end, and top surfaces of the bulge portions are higher than a top surface of an inner side portion of the top electrode;
   wherein the inner side portion is a convex polygonal region having edges, the bulge portions are arranged around the convex polygonal region to form an electrode frame with a polygonal shape, and the electrode frame includes a plurality of frame edges; and
   wherein the plurality of frame edges of the electrode frame has lateral width change within the acoustic mirror, and the lateral width change includes the fact that a lateral width of a portion of at least one of the plurality of frame edges of the electrode frame that is located within the acoustic mirror is different from a lateral width of a portion of at least one of the remaining frame edges of the plurality of frame edges that is located within the acoustic mirror.
2. The resonator according to 1, wherein
   lateral widths of the plurality of frame edges of the electrode frame are combinations of widths, which corresponds to peak values of a parallel impedance value, in a width change curve of the parallel impedance value of the resonator along with width change of a protrusion structure.
3. The resonator according to 1 or 2, wherein
   the resonator includes an insertion layer that is located below the top electrode, and the insertion layer is configured in such a manner that the bulge portions are higher than the top surface of the inner side portion of the top electrode.
4. The resonator according to 3, wherein
   the insertion layer is arranged between the top electrode and the piezoelectric layer, the bulge portions include a bridge portion located at the top-electrode connection end and a wing portion located at the non-top-electrode connection end, the insertion layer includes an insertion frame located in the acoustic mirror in a lateral direction, and the insertion frame and the electrode frame have a same inner side boundary and a same outer side boundary in the lateral direction.
5. The resonator according to 4, wherein
   the insertion layer is made of a conductive material, and within the acoustic mirror in the lateral direction, the conductive material fills a space between the top electrode and the piezoelectric layer in a thickness direction of the resonator.
6. The resonator according to 5, wherein
   the insertion layer is a single layer.
7. The resonator according to 6, wherein
   the plurality of frame edges of the insertion frame is straight frame edges of which the inner side boundaries and the outer side boundaries are linear.
8. The resonator according to 6, wherein
   the inner side boundary and/or the outer side boundary of at least one of the plurality of frame edges of the insertion frame has a concave-convex shape.
9. The resonator according to 5, wherein
   the insertion layer includes a plurality of insertion sub-layers that is sequentially arranged from an inner side to an outer side in the lateral direction, the plurality of frame edges of the insertion frame forms a step frame edge with a height increasing from the inner side to the outer side, and each of the plurality of insertion sub-layers forms a corresponding insertion sub-frame.
10. The resonator according to 9, wherein
   the lateral width of at least one of the plurality of frame edges of the insertion frame within the acoustic mirror is different from the lateral width of at least one of the remaining frame edges of the plurality of frame edges within the acoustic mirror; and/or in at least one of the plurality of insertion sub-frames, the lateral width of at least one of the plurality of frame edges within the acoustic mirror is different from the lateral width of at least one of the remaining frame edges of the plurality of frame edges within the acoustic mirror.
11. The resonator according to 10, wherein
   the plurality of frame edges of the plurality of insertion sub-frames is straight frame edges of which the inner side boundaries and the outer side boundaries are linear.
12. The resonator according to 10, wherein
   the inner side boundary and/or the outer side boundary of at least one of the plurality of frame edges of at least one of the plurality of insertion sub-frames has a concave-convex shape.
13. The resonator according to 4, wherein
   the insertion layer is made of a non-conductive medium, and within the acoustic mirror in the lateral direction, the non-conductive medium fills a space between the top electrode and the piezoelectric layer in a thickness direction of the resonator, and the non-conductive medium is a solid medium or air.
14. The resonator according to 13, wherein
   the plurality of frame edges of the insertion layer is straight frame edges of which the inner side boundaries and the outer side boundaries are linear.
15. The resonator according to 13, wherein
   the inner side boundary and/or the outer side boundary of at least one of the plurality of frame edges of the insertion layer is in a concave-convex shape.
16. The resonator according to 13, wherein
   the lateral width of at least one of the plurality of frame edges of the insertion frame within the acoustic mirror is different from the lateral width of at least one of the remaining frame edge of the plurality of frame edges within the acoustic mirror.
17. The resonator according to 4, wherein
   the insertion layer includes a plurality of insertion sub-layers that is sequentially arranged from an inner side to an outer side in the lateral direction, the plurality of frame edges of the insertion layer forms a step frame edge from the inner side to the outer side, each of the plurality of insertion sub-layers is made of a conductive material and forms a corresponding insertion sub-frame, a non-conductive medium layer is provided between an outermost one of the plurality of insertion sub-layers in the lateral direction and a top surface of the piezoelectric layer, the non-conductive medium layer forms a non-conductive frame, and the non-conductive medium layer is a solid medium layer or air.
18. The resonator according to 17, wherein
   the frame edges of the insertion sub-frame and the non-conductive frame are straight frame edges of which the inner side boundaries and the outer side boundaries are linear.
19. The resonator according to 17, wherein
   the inner side boundary and/or the outer side boundary of at least one of the plurality of frame edges of the insertion sub-frame or the non-conductive frame is in a concave-convex shape.
20. The resonator according to 17, wherein
   the lateral width of at least one of the plurality of frame edges of the insertion frame within the acoustic mirror is different from the lateral width of at least one of the remaining frame edges of the plurality of frame edges within the acoustic mirror; and/or
   the lateral width of at least one of the plurality of frame edges of at least one of the plurality of insertion sub-frames and/or the non-conductive frame within the acoustic mirror is different from the lateral width of at least one remaining frame edge within the acoustic mirror.
21. The resonator according to 17, wherein
   the plurality of insertion sub-layers includes an inner sub-layer and an outer sub-layer, and the non-conductive medium layer has a width that is equal to a width of the outer sub-layer; or the plurality of insertion sub-layers includes an inner sub-layer and an outer sub-layer, and the non-conductive medium layer has a width that is less than a width of the outer sub-layer.
22. The resonator according to 4, wherein
   the insertion layer has a thickness that is less than a thickness of the top electrode.
23. The resonator according to 13, wherein
   the insertion layer has a thickness that is less than a thickness of the top electrode.
24. The resonator according to 4, wherein
   the insertion layer is arranged between the piezoelectric layer and the bottom electrode.
25. A bulk acoustic wave resonator includes:
   a sub strate;
   an acoustic mirror;
   a bottom electrode;
   a top electrode; and a piezoelectric layer,
   wherein the top electrode is provided with bulge portions at both a top-electrode connection end and a non-top-electrode connection end, and top surfaces of the bulge portions are higher than a top surface of an inner side portion of the top electrode;
   wherein the inner side portion is a convex polygonal region having edges, the bulge portions are arranged around the convex polygonal region to form an electrode frame with a polygonal shape, and the electrode frame includes a plurality of frame edges; and
   wherein the plurality of frame edges of the electrode frame has lateral width change within the acoustic mirror, and the lateral width change includes the fact that at least one frame edge of the plurality of frame edges of the electrode frame has a width that is variable in an extension direction of the at least one frame edge.
26. A method of adjusting an electromechanical coupling coefficient of the bulk acoustic wave resonator according to any one of 1-25 includes a step of
   adjusting, by adjusting the widths of the plurality of frame edges of the electrode frame within the acoustic mirror in the lateral direction, the electromechanical coupling coefficient.
27. The method according to 26 further includes a step of:
   adjusting, by selecting a ratio of a number of frame edges of the plurality of frame edges that have adjusted widths to a total number of the plurality of frame edges of the electrode frame, the electromechanical coupling coefficient.
28. A filter includes:
   a series branch including a plurality of series resonators; and a plurality of parallel branches, each of the plurality of parallel branches including a parallel resonator, wherein at least one resonator of the parallel resonators and the plurality of series resonators has an electromechanical coupling coefficient that is different from electromechanical coupling coefficients of other resonators of the parallel resonators and the plurality of series resonators, and the at least one resonator is the bulk acoustic wave resonator according to any one of 1-25.
29. The filter according to 28, wherein
   at least two resonators of the parallel resonators and the plurality of series resonators are the resonators according to any one of 1-25, and the at least two resonators have electromechanical coupling coefficients different from each other due to the lateral width change of the plurality of frame edges of the electrode frame within the acoustic mirror.
30. An electronic device includes the filter according to 28 or 29 or the bulk acoustic wave resonator according to any one of 1-25.

It should be noted that, the electronic device herein includes, but is not limited to, intermediate products such as a radio-frequency front end and a filtering and amplifying module, and terminal products such as a mobile phone, WIFI and an unmanned aerial vehicle.

Although the embodiments of the present disclosure have been shown and described, it will be understood by those of ordinary skilled in the art that changes may be made to these embodiments without departing from the principles and spirit of the present disclosure, and the scope of the present disclosure is determined by the appended claims and their equivalents.

## Claims

1. A bulk acoustic wave resonator, comprising:
a substrate;
an acoustic mirror;
a bottom electrode;
a top electrode; and
a piezoelectric layer,
wherein the top electrode is provided with bulge portions at both a top-electrode connection end and a non-top-electrode connection end, and top surfaces of the bulge portions are higher than a top surface of an inner side portion of the top electrode;
wherein the inner side portion is a convex polygonal region having edges, the bulge portions are arranged around the convex polygonal region to form an electrode frame with a polygonal shape, and the electrode frame comprises a plurality of frame edges; and
wherein the plurality of frame edges of the electrode frame has lateral width change within the acoustic mirror, and the lateral width change comprises the fact that a lateral width of a portion of at least one of the plurality of frame edges of the electrode frame that is located within the acoustic mirror is different from a lateral width of a portion of at least one of the remaining frame edges of the plurality of frame edges that is located within the acoustic mirror.

2. The resonator according to claim 1, wherein lateral widths of the plurality of frame edges of the electrode frame are combinations of widths, which corresponds to peak values of a parallel impedance value, in a width change curve of the parallel impedance value of the resonator along with width change of a protrusion structure.

3. The resonator according to claim 1 or 2, further comprising:
an insertion layer located below the top electrode, the insertion layer being configured in such a manner that the bulge portions are higher than the top surface of the inner side portion of the top electrode.

4. The resonator according to claim 3, wherein the insertion layer is arranged between the top electrode and the piezoelectric layer, the bulge portions comprise a bridge portion located at the top-electrode connection end and a wing portion located at the non-top-electrode connection end, the insertion layer comprises an insertion frame located in the acoustic mirror in a lateral direction, and the insertion frame and the electrode frame have a same inner side boundary and a same outer side boundary in the lateral direction.

5. The resonator according to claim 4, wherein the insertion layer is made of a conductive material, and within the acoustic mirror in the lateral direction, the conductive material fills a space between the top electrode and the piezoelectric layer in a thickness direction of the resonator.

6. The resonator according to claim 5, wherein the insertion layer is a single layer.

7. The resonator according to claim 6, wherein the plurality of frame edges of the insertion frame is straight frame edges of which the inner side boundaries and the outer side boundaries are linear.

8. The resonator according to claim 6, wherein the inner side boundary and/or the outer side boundary of at least one of the plurality of frame edges of the insertion frame has a concave-convex shape.

9. The resonator according to claim 5, wherein the insertion layer comprises a plurality of insertion sub-layers that is sequentially arranged from an inner side to an outer side in the lateral direction, the plurality of frame edges of the insertion frame forms a step frame edge with a height increasing from the inner side to the outer side, and each of the plurality of insertion sub-layers forms a corresponding insertion sub-frame.

10. The resonator according to claim 9, wherein the lateral width of at least one of the plurality of frame edges of the insertion frame within the acoustic mirror is different from the lateral width of at least one of the remaining frame edges of the plurality of frame edges within the acoustic mirror; and/or
in at least one of the plurality of insertion sub-frames, the lateral width of at least one of the plurality of frame edges within the acoustic mirror is different from the lateral width of at least one of the remaining frame edges of the plurality of frame edges within the acoustic mirror.

11. The resonator according to claim 10, wherein the plurality of frame edges of the plurality of insertion sub-frames is straight frame edges of which the inner side boundaries and the outer side boundaries are linear.

12. The resonator according to claim 10, wherein the inner side boundary and/or the outer side boundary of at least one of the plurality of frame edges of at least one of the plurality of insertion sub-frames has a concave-convex shape.

13. The resonator according to claim 4, wherein the insertion layer is made of a non-conductive medium, and within the acoustic mirror in the lateral direction, the non-conductive medium fills a space between the top electrode and the piezoelectric layer in a thickness direction of the resonator, and the non-conductive medium is a solid medium or air.

14. The resonator according to claim 13, wherein the plurality of frame edges of the insertion layer is straight frame edges of which the inner side boundaries and the outer side boundaries are linear.

15. The resonator according to claim 13, wherein the inner side boundary and/or the outer side boundary of at least one of the plurality of frame edges of the insertion layer is in a concave-convex shape.

16. The resonator according to claim 13, wherein the lateral width of at least one of the plurality of frame edges of the insertion frame within the acoustic mirror is different from the lateral width of at least one of the remaining frame edge of the plurality of frame edges within the acoustic mirror.

17. The resonator according to claim 4, wherein the insertion layer comprises a plurality of insertion sub-layers that is sequentially arranged from an inner side to an outer side in the lateral direction, the plurality of frame edges of the insertion layer forms a step frame edge from the inner side to the outer side, each of the plurality of insertion sub-layers is made of a conductive material and forms a corresponding insertion sub-frame, a non-conductive medium layer is provided between an outermost one of the plurality of insertion sub-layers in the lateral direction and a top surface of the piezoelectric layer, the non-conductive medium layer forms a non-conductive frame, and the non-conductive medium layer is a solid medium layer or air.

18. The resonator according to claim 17, wherein the frame edges of the insertion sub-frame and the non-conductive frame are straight frame edges of which the inner side boundaries and the outer side boundaries are linear.

19. The resonator according to claim 17, wherein the inner side boundary and/or the outer side boundary of at least one of the plurality of frame edges of the insertion sub-frame or the non-conductive frame is in a concave-convex shape.

20. The resonator according to claim 17, wherein the lateral width of at least one of the plurality of frame edges of the insertion frame within the acoustic mirror is different from the lateral width of at least one of the remaining frame edges of the plurality of frame edges within the acoustic mirror; and/or
the lateral width of at least one of the plurality of frame edges of at least one of the plurality of insertion sub-frames and/or the non-conductive frame within the acoustic mirror is different from the lateral width of at least one remaining frame edge within the acoustic mirror.

21. The resonator according to claim 17, wherein the plurality of insertion sub-layers comprises an inner sub-layer and an outer sub-layer, and the non-conductive medium layer has a width that is equal to a width of the outer sub-layer; or
the plurality of insertion sub-layers comprises an inner sub-layer and an outer sub-layer, and the non-conductive medium layer has a width that is less than a width of the outer sub-layer.

22. The resonator according to claim 4, wherein the insertion layer has a thickness that is less than a thickness of the top electrode.

23. The resonator according to claim 13, wherein the insertion layer has a thickness that is less than a thickness of the top electrode.

24. The resonator according to claim 4, wherein the insertion layer is arranged between the piezoelectric layer and the bottom electrode.

25. A bulk acoustic wave resonator, comprising:
a substrate;
an acoustic mirror;
a bottom electrode;
a top electrode; and
a piezoelectric layer,
wherein the top electrode is provided with bulge portions at both a top-electrode connection end and a non-top-electrode connection end, and top surfaces of the bulge portions are higher than a top surface of an inner side portion of the top electrode;
wherein the inner side portion is a convex polygonal region having edges, the bulge portions are arranged around the convex polygonal region to form an electrode frame with a polygonal shape, and the electrode frame comprises a plurality of frame edges; and
wherein the plurality of frame edges of the electrode frame has lateral width change within the acoustic mirror, and the lateral width change comprises the fact that at least one frame edge of the plurality of frame edges of the electrode frame has a width that is variable in an extension direction of the at least one frame edge.

26. A method of adjusting an electromechanical coupling coefficient of the bulk acoustic wave resonator according to any one of claims 1-25, comprising:
adjusting, by adjusting the widths of the plurality of frame edges of the electrode frame within the acoustic mirror in the lateral direction, the electromechanical coupling coefficient.

27. The method according to claim 26, further comprising:
adjusting, by selecting a ratio of a number of frame edges of the plurality of frame edges that have adjusted widths to a total number of the plurality of frame edges of the electrode frame, the electromechanical coupling coefficient.

28. A filter, comprising:
a series branch comprising a plurality of series resonators; and
a plurality of parallel branches, each of the plurality of parallel branches comprising a parallel resonator,
wherein at least one resonator of the parallel resonators and the plurality of series resonators has an electromechanical coupling coefficient that is different from electromechanical coupling coefficients of other resonators of the parallel resonators and the plurality of series resonators, and the at least one resonator is the bulk acoustic wave resonator according to any one of claims 1-25.

29. The filter according to claim 28, wherein at least two resonators of the parallel resonators and the plurality of series resonators are the resonators according to any one of claims 1-25, and the at least two resonators have electromechanical coupling coefficients different from each other due to the lateral width change of the plurality of frame edges of the electrode frame within the acoustic mirror.

30. An electronic device, comprising the filter according to claim 28 or 29 or the bulk acoustic wave resonator according to any one of claims 1-25.
